(19) Europäisches Patentamt / European Patent Office / Office européen des brevets

(11) **EP 4 570 943 A1**

(12) **EUROPEAN PATENT APPLICATION**
published in accordance with Art. 153(4) EPC

(43) Date of publication:
**18.06.2025  Bulletin 2025/25**

(21) Application number: **23860426.8**

(22) Date of filing: **30.08.2023**

(51) International Patent Classification (IPC):
***C23C 14/34*** (2006.01)

(52) Cooperative Patent Classification (CPC):
**C23C 14/34**

(86) International application number:
**PCT/JP2023/031580**

(87) International publication number:
**WO 2024/048664 (07.03.2024 Gazette 2024/10)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **02.09.2022  JP 2022140343**

(71) Applicant: **Tosoh Corporation
Yamaguchi 746-8501 (JP)**

(72) Inventors:
• **SHONO, Daiki
  Ayase-shi, Kanagawa 252-1123 (JP)**
• **MESUDA, Masami
  Ayase-shi, Kanagawa 252-1123 (JP)**

(74) Representative: **Müller-Boré & Partner
Patentanwälte PartG mbB
Friedenheimer Brücke 21
80639 München (DE)**

(54) **MOLYBDENUM SPUTTERING TARGET, METHOD FOR PRODUCING SAME, AND METHOD FOR PRODUCING SPUTTERING FILM USING MOLYBDENUM SPUTTERING TARGET**

(57) A molybdenum sputtering target includes molybdenum. The molybdenum sputtering target contains crystal grains having an average crystal grain size of less than 10 $\mu$m and has a relative density of 99.6% or more and an oxygen content of 100 ppm by mass or less.

*Fig.4*

## Description

### Technical Field

The present disclosure relates to a molybdenum sputtering target, a method for producing the same, and a method for producing a sputtering film using a molybdenum sputtering target.

### Background Art

Sputtering targets (hereinafter, also referred to as "targets") containing a metal such as molybdenum are used for, for example, forming light-shielding films for lithography masks. With the progress of lithographic technologies, characteristics required for the targets have also become higher, and currently, there has been a demand for a target that can further reduce the generation of impurity particles (so-called particles) of a metal oxide or the like during formation of a sputtering film. In order to reduce the amount of particles generated, an increase in the density, a reduction in the oxygen content, and a reduction in the crystal grain size of targets have hitherto been studied.

### Citation List

### Patent Literature

PTL 1: Japanese Unexamined Patent Publication No. 2005-154814
PTL 2: International Publication No. 2012/043227
PTL 3: Japanese Unexamined Patent Publication No. 2000-045066

### Summary of Invention

### Technical Problem

Recently, in order to further reduce particles, there has been a demand for a molybdenum sputtering target having a high density and a low oxygen content and further having fine crystal grains. However, it is difficult to reduce the crystal grain size in a target having a high density and a low oxygen content.

In general, in sintering of a molybdenum powder to achieve a high density or that of a molybdenum powder having or low oxygen content, crystal grains are likely to grow, and the crystal grain size tends to increase. More specifically, when hot isostatic pressing (hereinafter, also referred to as "HIP") sintering of molybdenum is performed under high temperature-high pressure conditions such that the resulting target has a high density, crystal grains grow largely. In sintering of molybdenum with a low oxygen content, similarly, crystal grains grow largely because the amount of impurities that inhibit the growth of crystal grains is small. Thus, there is a trade-off relationship between an increase in the density and a reduction in the grain size and between a reduction in the oxygen content and a reduction in the grain size.

For example, PTL 1 reports targets having fine grain sizes; targets having an average grain size of 2 $\mu$m and targets having an average grain size of 8 $\mu$m are reported in Comparative Examples 1 and 2 and Comparative Examples 7 and 8, respectively. However, the density of each of the targets is not sufficiently improved, and arcing is likely to occur.

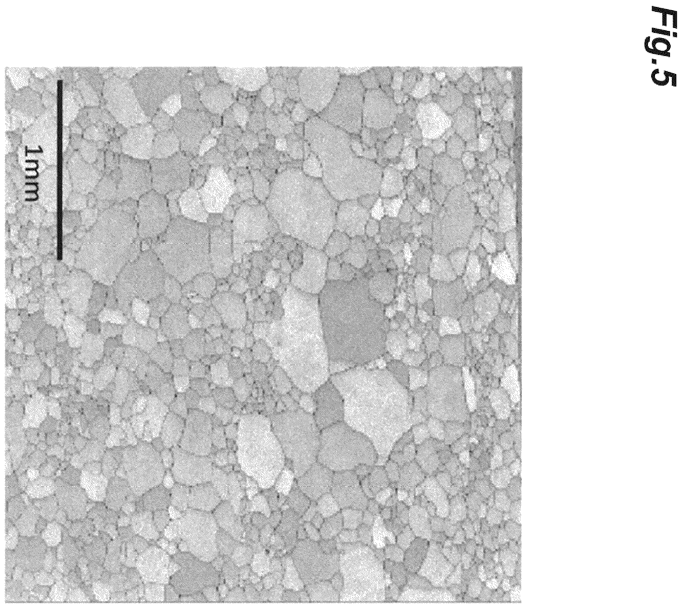

PTL 2 reports, as Example No. 27, a target having an oxygen content of 85 ppm; however, the average grain size measured by the intercept method from the SEM image of Fig. 5 is about 15 $\mu$m.

PTL 3 reports that a molybdenum sintered body immediately after HIP sintering has a density of 100% and an average crystal grain size of 11 $\mu$m. As described above, in the sintered body immediately after sintering, an increase in the density and a reduction in the grain size are in a trade-off relationship, and it is difficult to further reduce the grain size with HIP sintering alone.

None of the documents reports a molybdenum sputtering target having a high density and a low oxygen content and further having fine crystal grains.

An object of the present disclosure is to provide at least one of a molybdenum sputtering target that has a high density and a low oxygen content, that further has fine crystal grains, and that achieves a reduction in the generation of particles during deposition, a method for producing the same, and a method for producing a sputtering film using the molybdenum sputtering target.

**Solution to Problem**

Specifically, the present invention is defined in the claims, and the gist of the present disclosure is as follows.

(1) A molybdenum sputtering target containing molybdenum, in which the molybdenum sputtering target contains crystal grains having an average crystal grain size of less than 10 μm and has a relative density of 99.6% or more and an oxygen content of 100 ppm by mass or less.
(2) The molybdenum sputtering target according to (1), in which a purity is 99.9% or more.
(3) The molybdenum sputtering target according to (1) or (2), in which a maximum deviation of the average crystal grain size of the crystal grains in a depth direction is 3 μm or less.
(4) The molybdenum sputtering target according to (3), in which the maximum deviation is less than 1 μm.
(5) The molybdenum sputtering target according to (4), in which the maximum deviation is 0.2 μm or less.
(6) The molybdenum sputtering target according to any one of (1) to (5), in which the average crystal grain size is 5 μm or less.
(7) The molybdenum sputtering target according to any one of (1) to (6), in which an average KAM value is 0.5° or less.
(8) The molybdenum sputtering target according to any one of (1) to (7), in which a sputtering surface has an area of 200 cm$^2$ or more.
(9) A method for producing a sputtering film, the method including performing sputtering using the sputtering target according to any one of (1) to (8) to produce a sputtering film.
(10) A method for producing the molybdenum sputtering target according to any one of (1) to (8), the method including a refining step of refining crystal grains in a molybdenum ingot, in which the refining step includes a plastic working step of subjecting the molybdenum ingot to plastic working to obtain a plastically worked product and a heat treatment step of subjecting the plastically worked product to heating treatment.

**Advantageous Effects of Invention**

The present disclosure provides at least one of a molybdenum sputtering target that has a high density and a low oxygen content, that further has fine crystal grains, and that achieves a reduction in the generation of particles during deposition, a method for producing the same, and a method for producing a sputtering film using the molybdenum sputtering target.

**Brief Description of Drawings**

[Fig. 1] Fig. 1 is a schematic top view of a target for illustrating an observation region A.
[Fig. 2] Fig. 2 is a schematic sectional view of a target for illustrating a sampling portion B.
[Fig. 3] Fig. 3 is a sectional view illustrating a substrate with a sputtering film produced by a method for producing a sputtering film according to an embodiment of the present disclosure.
[Fig. 4] Fig. 4 is a view showing a SEM observation image of a sampling portion B in a cross section of a target of Example 1.
[Fig. 5] Fig. 5 is a view showing a SEM observation image of a sampling portion B in a cross section of Comparative Example 1.

**Description of Embodiments**

The present disclosure will be described in detail with reference to an embodiment; however, the present disclosure is not limited to the following embodiment.
Configurations and parameters disclosed in the present Description can be arbitrarily combined, and the upper and lower limits of values disclosed in the present Description can be arbitrarily combined.

<Molybdenum sputtering target>

A target of the present embodiment is a molybdenum sputtering target containing molybdenum. The target of the present embodiment is more preferably a metal sputtering target made of molybdenum.
The oxygen content of the target of the present embodiment is 100 ppm by mass or less, more preferably 30 ppm by mass or less, still more preferably 20 ppm by mass or less, still further more preferably 10 ppm by mass or less, particularly preferably 7 ppm by mass or less. When the oxygen content of the target is within the above range, entry of oxygen in a film can be reduced during deposition to suppress the generation of particles caused by entry of oxygen. Moreover, the target of the present embodiment can provide a sputtering film having higher crystallinity. The oxygen content may be 0 ppm by mass or more, more than 0 ppm by mass, 0.1 ppm by mass or more, 0.5 ppm by mass or more, or 1 ppm by mass or more. The oxygen content is preferably 0 ppm by mass or more and 100 ppm by mass or less, more preferably more than 0 ppm by mass and 30 ppm by mass or less, still more preferably 0.1 ppm by mass or more and 20 ppm by mass or less.

The oxygen content of the target can be measured with an oxygen/nitrogen analyzer (apparatus name: ON736, manufactured by LECO Corporation).

The target of the present embodiment contains crystal grains, and an average crystal grain size (average grain size) of the crystal grains is less than 10 $\mu$m, more preferably 8 $\mu$m or less, still more preferably 5 $\mu$m or less, still further more preferably 4 $\mu$m or less, particularly preferably 2 $\mu$m or less. The average crystal grain size is more than 0 $\mu$m, preferably 0.1 $\mu$m or more, or 1 $\mu$m or more. The average crystal grain size is preferably more than 0 $\mu$m and 8 $\mu$m or less, more preferably 0.1 $\mu$m or more and 5 $\mu$m or less, still more preferably 1 $\mu$m or more and 4 $\mu$m or less.

When the average crystal grain size is in a range of less than 10 $\mu$m, the generation of particles during deposition is reduced, and detachment of redeposited sputtered particles can also be suppressed while an abnormal discharge is suppressed.

The measurement of the average crystal grain size can be performed using scanning electron microscope-electron backscatter diffraction (hereinafter, also referred to as "SEM-EBSD"). The microstructure of the target is observed under the following measurement conditions and using the following programs, and the measurement can be performed for all observed crystal grains using an analysis program (for example, Aztec Crystal). Specifically, a rotation angle between adjacent measurement points, that is, the orientation difference (°) between measurement points is measured by EBSD in a SEM image, and a closed loop with continuous and uninterrupted pixel boundaries whose rotation angle exceeds 10° is regarded as a crystal grain boundary, and the region in the loop is defined as one crystal grain. The diameter of a circle having an area equivalent to the area of the region constituting a crystal grain is regarded as a grain size of the crystal grain, and the arithmetic mean of the grain sizes of all crystal grains measured can be calculated as the average crystal grain size.

(Measurement conditions)

Beam conditions: Accelerating voltage 20 kV, Illumination current 100 $\mu$A
Work distance: 10 mm
(Programs used)
Measurement program: AZtec
Analysis program: AZtec Crystal

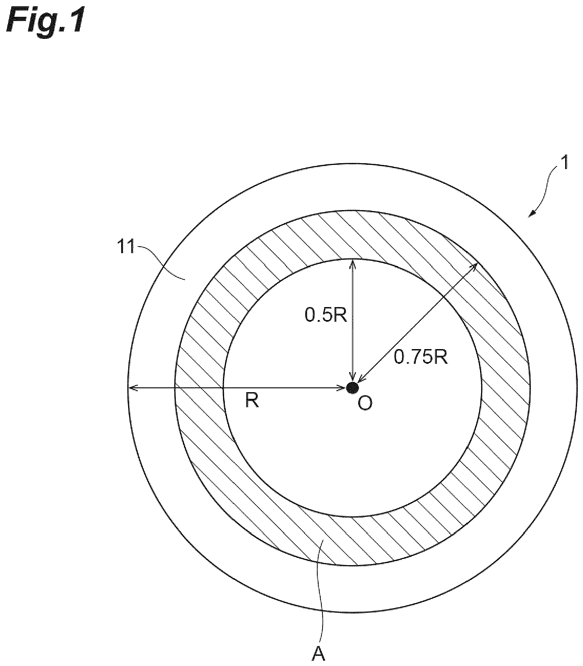

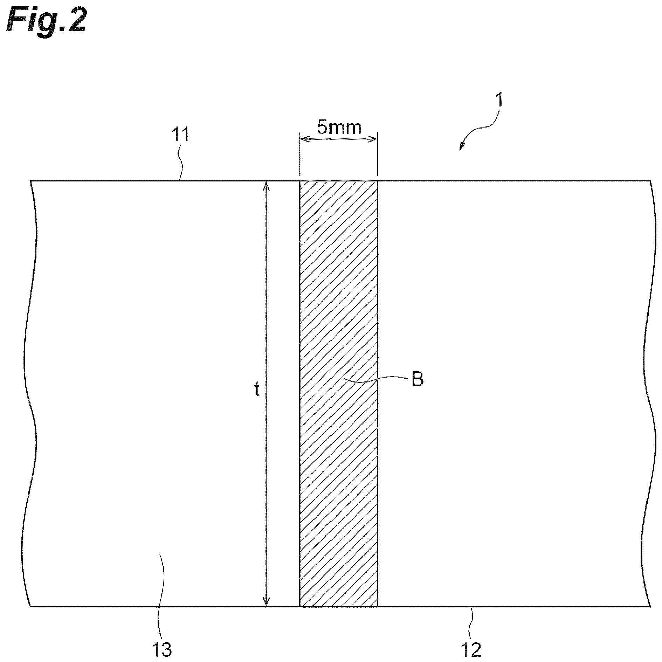

Figs. 1 and 2 are schematic views of a target. Fig. 1 is a schematic top view of the target for illustrating an observation region A, and Fig. 2 is a schematic sectional view of the target for illustrating a sampling portion B. The shape of the target is not particularly limited; however, in Figs. 1 and 2, the description will be made on the assumption that the target has a disk shape. In Fig. 2, a sputtering surface 11 is a surface facing an object on which a film is to be formed, such as a substrate, during deposition and is a surface that comes in contact with an atmosphere gas converted into plasma. In contrast, a bonding surface 12 is a surface to be joined to a backing plate. As illustrated in Fig. 2, the sputtering surface 11 and the bonding surface 12 each correspond to a flat surface of the disk (hereinafter, the sputtering surface is also referred to as a "front surface", and the bonding surface is also referred to as a "back surface" for the sake of convenience).

As illustrated in Fig. 1, an annular region on a circular sputtering surface 11 of a target 1 is defined as an observation region A. When the distance from a center O of the circle to the outer circumference thereof (the radius of the circular sputtering surface 11) is denoted by R, the observation region A is a region located between a circle centered on O and having a radius of 0.5R and a circle centered on O and having a radius of 0.75R. In the case where the sputtering surface of the target has a rectangular shape, when the distance from an intersection P of the diagonal lines to a point Q on the outer periphery of the rectangle is denoted by PQ, the observation region A is a region located between a rectangle in which the distance from P, which is the intersection of the diagonal lines, to the outer periphery is 0.5PQ and a rectangle in which the distance from P, which is the intersection of the diagonal lines, to the outer periphery is 0.75PQ. In a cross section 13 of the observation region A, a region of 5 mm in width × t (mm) in overall thickness is defined as a sampling portion B (see Fig. 2), and for the sampling portion B, the average crystal grain size can be determined by SEM-EBSD. The sampling portion B may be selected in any manner as long as the portion is located within the observation region A. In the present Description, dividing a target by cutting the target parallel to the sputtering surface will be described later. Also for each of the resulting divided segments, a region of 5 mm in width × t' (mm) in overall thickness of the divided segment is referred to as a "sampling portion B'" as in the sampling portion B. Measurement conditions and programs used for SEM-EBSD are described below.

(Measurement conditions)

Beam conditions: Accelerating voltage 20 kV, Illumination current 100 μA
Work distance: 10 mm (Programs used)
Measurement program: AZtec
Analysis program: AZtec Crystal

In the measurement of the average crystal grain size, a sample may be prepared by cutting a target using a common cutting method (which may be, for example, a cutting method with at least one of a fine cutter and a water jet) to expose a cross section of the target. Prior to the measurement, the sample may be pretreated by being mirror-polished with SiC abrasive paper and by buffing, followed by electrolytic etching with a 5 vol% aqueous solution of sulfuric acid.

The average KAM value of the target of the present embodiment is preferably 1° or less, more preferably 0.5° or less or 0.4° or less. This reduces distortion inside the target to reduce the occurrence of cracking and warpage during machining and easily reduces the cracking of the sputtering surface of the target and the generation of particles during deposition to thereby stabilize the etching rate. The average KAM value is calculated from the arithmetic mean of the KAM values at all the measurement points. The average KAM value may be 0° or more, or 0.1° or more. The average KAM value is preferably 0° or more and 1° or less, more preferably 0° or more and 0.5° or less, still more preferably 0.1° or more and 0.4° or less.

The maximum deviation of the average crystal grain size of the target of the present embodiment in a depth direction (hereinafter also simply referred to as "maximum deviation") is preferably 3 μm or less, more preferably 1 μm or less. When the maximum deviation is 3 μm or less, the deposition rate of a sputtering film is likely to be uniform. The maximum deviation may be less than 1 μm, 0.8 μm or less, 0.6 μm or less, 0.4 μm or less, 0.2 μm or less, or 0.1 μm or less.

The maximum deviation can be, for example, 0 μm or more, 0.01 μm or more, 0.03 μm or more, or 0.05 μm or more. The maximum deviation is preferably 0 μm or more and 3 μm or less, more preferably 0.01 μm or more and less than 1 μm, and still more preferably 0.03 μm or more and 0.2 μm or less.

Herein, the depth direction refers to the thickness direction of the target. The maximum deviation of the average crystal grain size in the depth direction refers to the maximum deviation between the average crystal grain sizes on a surface on the sputtering surface side of the sampling portion B' of each of three divided segments prepared by cutting the target in a direction parallel to the sputtering surface at positions at which the target is divided into three equal segments in the depth direction. The maximum deviation is determined by, for example, cutting the target, subsequently subjecting each divided segment to surface polishing, calculating the average crystal grain size in each divided segment, and calculating the difference between the maximum value and the minimum value of the average crystal grain sizes.

The relative density of the target of the present embodiment is 99.6% or more and is preferably 99.7% or more, 99.8% or more, 99.9% or more, 99.95% or more, or 99.99% or more. If the relative density is less than 99.6%, particles are likely to be generated. A relative density of more than 99.6% improves the strength of the target to facilitate the application of a high discharge power to the target. This improves the deposition rate in the case of forming a sputtering film by sputtering the target and tends to increase productivity of a sputtering film. The relative density is 100% or less. The relative density is preferably 99.6% or more and 100% or less, more preferably 99.9% or more and 100% or less, still more preferably 99.99% or more and 100% or less.

The relative density of the target can be calculated by the following method. Specifically, a measured density of the target is measured in accordance with JIS R 1634, and the measured density is divided by the true density to calculate the relative density. In the present embodiment, the true density of molybdenum may be 10.22 g/cm$^3$.

The area of the sputtering surface of the target of the present embodiment is not particularly limited but is preferably 200 cm$^2$ or more, more preferably 350 cm$^2$ or more, still more preferably 800 cm$^2$ or more. An area of the sputtering surface of 200 cm$^2$ or more can increase the deposition area of a sputtering film. Accordingly, a film with a large area which usually needs to be formed using a plurality of targets can also be formed using a single target. Moreover, mixing of impurities from boundary portions between targets can be suppressed. The upper limit of the area of the sputtering surface is not particularly limited but is, for example, 3,000 cm$^2$, 2,000 cm$^2$, or 1,500 cm$^2$. The area of the sputtering surface can be calculated, as the area of a circle, using the diameter of the sputtering surface. The diameter of the sputtering surface can be measured with a vernier caliper or a three-dimensional measuring device. The area of the sputtering surface is preferably 200 cm$^2$ or more and 3,000 cm$^2$ or less, more preferably 350 cm$^2$ or more and 3,000 cm$^2$ or less, still more preferably 800 cm$^2$ or more and 2,000 cm$^2$ or less.

The purity of the target of the present embodiment is not particularly limited but is preferably 99.9% or more, more preferably 99.99% or more, still more preferably 99.995% or more. The expression "the purity of the target is 99.9% or more" means that the content of molybdenum metal contained in the target of the present embodiment is 99.9% by mass or more, that is, the content of metal elements (impurity metal elements) other than molybdenum metal contained in the target of the present embodiment is 0.1% by mass or less. When the purity is 99.9% or more, the generation of particles originating from impurities is more likely to be suppressed. For the notation of purity, "4N" represents a purity of 99.99% or more, "5N" represents a purity of 99.999% or more, and "4N8" represents a purity of 99.998% or more. In the present Description, the purity of a target is calculated based only on metal elements for both powders and sintered bodies, and the oxygen content is not included in the calculation.

The purity of the target of the present embodiment can be measured by glow discharge mass spectrometry (GDMS). For example, a specimen with a size of 10 to 25 mm $\times$ 10 to 25 mm $\times$ 0.5 to 15 mm is cut out from the target to prepare a measurement sample. The measurement sample is pretreated by being subjected to polishing with SiC abrasive paper (#800), followed by ultrasonic cleaning in pure water for 10 minutes, dehydration with an alcohol, hot-air drying, and subsequent vacuum packing. For the measurement sample after the pretreatment, the content of impurities (impurity metal elements) may be measured by a method according to ASTM F 1593, and the purity may be calculated on the basis of the content of impurities and the following formula.

$$\text{Purity (\%)} = 100 \text{ - content of impurities}$$

<Method for producing sputtering target>

Next, a method for producing a target of the present embodiment will be described.

The target of the present embodiment can be produced by a method including a refining step that includes a plastic working step of subjecting a molybdenum ingot to plastic working treatment to obtain a plastically worked product, and a heat treatment step of subjecting the plastically worked product to heating treatment. Specifically, the method for producing the target of the present embodiment includes a refining step of refining crystal grains in a molybdenum ingot, in which the refining step includes a plastic working step of subjecting the molybdenum ingot to plastic working to obtain a plastically worked product and a heat treatment step of subjecting the plastically worked product to heating treatment.

The method for producing the target of the present embodiment may include, before the refining step, an ingot preparation step of sintering, or melting and then cooling molybdenum metal (hereinafter, also referred to as a "raw material" or "raw material metal") to obtain an ingot.

(Ingot preparation step)

In the ingot preparation step, an ingot is prepared from the raw material by a sintering method or a melting method.

The form of the raw material is not limited as long as an ingot is obtained by sintering, or melting and then cooling the raw material, and such a form may be, for example, a powdered, granular, or flaky form.

The purity of the raw material metal is preferably 99.99% or more. The oxygen content of the raw material is 100 ppm by mass or less, preferably 30 ppm by mass or less, more preferably 20 ppm by mass or less, still more preferably 10 ppm by mass or less, particularly preferably 7 ppm by mass or less. A reduction in the oxygen content of the raw material enables a reduction in the oxygen content of the target. The oxygen content is preferably low but may be more than 0 ppm by mass, or 1 ppm by mass or more. The oxygen content of the raw material is preferably more than 0 ppm by mass and 100 ppm by mass or less, more preferably more than 0 ppm by mass and 30 ppm by mass or less, still more preferably 1 ppm by mass or more and 20 ppm by mass or less.

In the sintering method, an ingot is obtained by sintering the raw material. The type of sintering method may be, for example, at least one of a molding-sintering method and a pressure sintering method. Either sintering method may be used, but the pressure sintering method is preferably employed in order to improve the density. Examples of the pressure sintering method include a hot press method and a hot isostatic press method (hereinafter, also referred to as a "HIP method"), and the HIP method, which has a higher pressurizing capability, is preferably used. The firing temperature is not particularly limited, but is preferably 1,000°C or higher and 1,500°C or lower, more preferably 1,200°C or higher and 1,450°C or lower. When the firing temperature is within the above temperature range, the density and the average crystal grain size of a sintered body before rolling treatment can be predetermined values. The sintered body obtained can be used as the ingot.

In the melting method, an ingot is obtained by melting the raw material by heating to a temperature equal to or higher than the melting point and then performing cooling. The method of melting is not particularly limited as long as the oxygen content of the target becomes 100 ppm by mass or less. The method of melting may be, for example, one or more selected from the group consisting of skull melting, arc melting, and electron beam melting. In order to reduce the oxygen content and impurities in the target, electron beam melting is preferred.

The relative density of the ingot for the plastic working step is preferably 90% or more, more preferably 95% or more. When the relative density of the ingot is 90% or more, the strength of a target obtained from the ingot is improved. The relative density of the ingot may be, for example, 100% or less. The relative density of the ingot is preferably 90% or more and 100% or less, more preferably 95% or more and 100% or less.

The average crystal grain size of the ingot is preferably 10 $\mu$m or more and 400 $\mu$m or less. When the average crystal grain size is 10 $\mu$m or more, the density of the target to be obtained is improved. When the average crystal grain size of the ingot is 400 $\mu$m or less, the average crystal grain size of the target to be obtained tends to be reduced, and the number of times of plastic working treatment described later is decreased to thereby improve productivity of the target.

(Refining step)

The refining step is a step of refining crystal grains in the molybdenum ingot. The refining step includes a plastic working step of subjecting a molybdenum ingot to plastic working to obtain a plastically worked product, and a heat treatment step of subjecting the plastically worked product to heating treatment. By subjecting the ingot to the refining step, crystal grains in the ingot are refined to provide a target of the present embodiment having an average crystal grain size of less than 10 $\mu$m.

In the plastic working step, the ingot is subjected to plastic working to prepare a plastically worked product. The resulting plastically worked product is further subjected to the heat treatment step to thereby refine crystal grains of the ingot, thus obtaining the target of the present embodiment. Note that, before the plastic working treatment is performed, the ingot may be subjected to a grinding process to have a shape and a size suitable for plastic working. The processing method may be, for example, grinding with a surface grinder.

The means for the plastic working is not particularly limited as long as the crystal microstructure of the ingot can be fractured by the method, and, for example, rolling mill rolls can be used. In rolling with rolling mill rolls, the prepared ingot is compressed by passing the ingot through a gap between a pair of rolling mill rolls, the gap having a width smaller than the thickness of the ingot. This provides a rolled product. The resulting rolled product may be repeatedly passed through a gap between a pair of rolling mill rolls. Hereinafter, a step of passing an ingot or a rolled product through a gap between a pair of rolling mill rolls is also referred to as a "rolling pass" .

The rolling treatment is preferably performed while a temperature of the ingot to be rolled (hereinafter, also referred to as a "rolling temperature") is 200°C or higher and 1,500°C or lower. The rolling temperature is more preferably 500°C or higher and 1,200°C or lower, still more preferably 700°C or higher and 1,000°C or lower. When the rolling temperature is within the above range, strain can be left in the whole rolled sheet (rolled product), and therefore, crystal grains are likely to be refined by the subsequent heat treatment. A rolling temperature of 500°C or higher can reduce the occurrence of cracking, and a rolling temperature of 1,200°C or lower can suppress coarsening of crystal grains due to dynamic recrystallization.

The rolling reduction ratio of the ingot in each rolling pass is preferably set so as to be 6% or more and 20% or less of the thickness of the ingot before the rolling pass, more preferably 8% or more and 10% or less. When the rolling reduction ratio is 6% or more, the difference in the amount of deformation between the surface and the inside of the ingot during rolling can be small to suppress an orientation imbalance in the depth direction after recrystallization. When the rolling reduction ratio is 20% or less, cracking of the material can be reduced. When the rolling reduction ratio is 6% or more and 20% or less, strain can be uniformly introduced to the whole without cracking of the rolled product, enabling rolling in which the orientation imbalance is controlled.

The temperature difference between rolling mill rolls and the ingot is preferably 500°C or less, more preferably 300°C or less. When the difference between the roll temperature and the ingot temperature is 500°C or less, it is possible to reduce the occurrence of cracking caused by thermal stress due to the temperature gradient inside the ingot.

The plastically worked product obtained by plastic working is further subjected to the heat treatment step to provide a heat-treated product in which crystal grains are refined.

The heat treatment in the heat treatment step is performed at a temperature higher than the plastic working temperature in the immediately previous plastic working step. The heat treatment performed at a temperature equal to or higher than the plastic working temperature can release the strain introduced during plastic working to recrystallize metallic microstructure of molybdenum.

The heat treatment temperature is preferably 500°C or higher and 1,300°C or lower, preferably 700°C or higher and 1,100°C or lower. This promotes recrystallization of the metallic microstructure to refine the crystal grains of the target. When the plastically worked product is heated in a vacuum or inert gas atmosphere furnace at 1,300°C or lower, surface oxidation can be suppressed and an increase in the average crystal grain size tends to be less likely to occur, and thus a target of the present embodiment is likely to be obtained. When the heat treatment temperature is 500°C or higher, the deformed texture after plastic working can be recrystallized, and uniform recrystallized microstructure can be obtained. Through the heat treatment step described above, a heat-treated product is obtained.

The refining step may be repeatedly performed. Specifically, the heat-treated product obtained by subjecting the plastically worked product after the plastic working step to the heat treatment step may be subjected to the plastic working step and the heat treatment step again. When the refining step is repeatedly performed, the plastic working temperature in the second and subsequent refining steps is preferably lower than the plastic working temperature of an ingot or a plastically worked product in the immediately previous refining step. Specifically, the plastic working temperature is preferably 300°C or higher and lower than 800°C. When plastic working is performed at a temperature lower than that in the immediately previous refining step, strain can be further added while strain accumulated in the ingot or the plastically worked product in the immediately previous refining step is moderately maintained, strain can be uniformly provided inside the material, and crystal grains can be refined to reduce the grain size of the crystal grains.

An oxide may be formed on the surface of the heat-treated product after the refining step, and the heat-treated product has a large surface roughness. Therefore, the heat-treated product is preferably subjected to a surface polishing process. The processing method is not particularly limited, and may be, for example, grinding with a surface grinder. In order to remove oxidized scale on the surface of the heat-treated product, a portion from the surface of the heat-treated product to a depth of 0.5 mm or more is preferably ground. In the case where the refining step is repeatedly performed, the surface polishing process may be performed for at least a heat-treated product after the last heat treatment step.

Through the above treatment, the target of the present embodiment is obtained.

The obtained target may be joined (bonded) to a backing plate for use. Examples of the joining method include diffusion bonding, solder bonding, and friction stir welding, but the joining method is not particularly limited.

<Method for producing sputtering film>

Next, a method for producing a sputtering film of the present embodiment will be described.

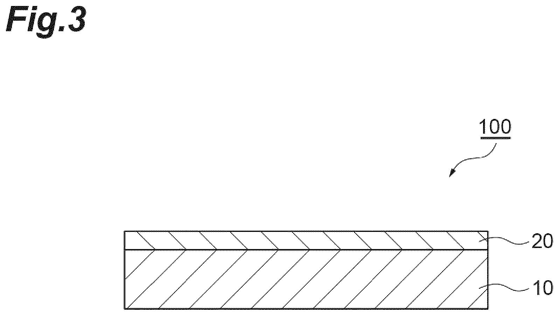

The method for producing a sputtering film of the present embodiment includes a step of performing sputtering using the target of the present embodiment to produce a sputtering film. As illustrated in Fig. 3, a substrate with a sputtering film 100 includes a substrate 10 and a sputtering film 20 formed on the substrate 10. Sputtering using the target of the present embodiment can suppress the generation of particles during deposition to provide a sputtering film with high film-thickness uniformity.

Example of the substrate 10 include, but are not particularly limited to, a glass substrate and a quartz substrate.

The temperature of the substrate 10 (deposition temperature) is not particularly limited but may be, for example, room temperature (25°C).

The type of process gas during deposition is not particularly limited as long as the gas causes sputtering upon discharging, and the gas may be, for example, argon.

The gas partial pressure during deposition is not particularly limited but may be, for example, 0.2 Pa or more and 2 Pa or less.

The discharge power during deposition is not particularly limited but may be, for example, 2.5 W/cm$^2$ or more and 50 W/cm$^2$ or less.

The deposition time is not particularly limited but may be, for example, 10 seconds or more and 100 seconds or less.

The sputtering can be performed using a typical sputtering apparatus. The conditions for sputtering are not particularly limited, and the sputtering can be performed, for example, under the following conditions.

Ultimate vacuum: $1 \times 10^{-4}$ Pa
Process gas: Ar
Gas partial pressure: 0.5 Pa
Deposition temperature: Room temperature
Substrate: Glass substrate
Discharge power: 10 W/cm$^2$
Deposition time: 60 seconds

**Examples**

The contents of the present disclosure will be described in more detail with reference to Examples and Comparative Examples; however, the present disclosure is not limited to Examples below.

(Example 1)

In a 350 mm × 350 mm × 350 mm soft iron can, 210 kg of a molybdenum powder (purity, 5N (i.e., purity, 99.999% or more); oxygen content, 15 ppm by mass) was enclosed and subjected to HIP treatment under the following conditions.

HIP treatment atmosphere: argon gas atmosphere
HIP treatment temperature: 1,250°C
HIP treatment pressure: 150 MPa
HIP treatment time: 5 hours

The resulting HIP-treated product was taken out from the can, and ground and cut to adjust the shape thereof to obtain a disk-shaped ingot having a diameter of 180 mm and a thickness of 50 mm.
The resulting ingot was heated to 800°C, and the heated ingot was then subjected to plastic working such that the compression rate in the thickness direction of the ingot did not exceed 10 mm/s. When the material temperature decreased to 500°C or lower during working, the ingot was reheated in a furnace at 800°C for 10 minutes, and the plastic working was repeated until the dimensions were 330 mm in diameter and 15 mm in thickness (that is, until the total rolling reduction ratio reached 70%) to obtain a plastically worked product.
The resulting plastically worked product (worked ingot) was heat-treated in a hydrogen atmosphere at a heat treatment temperature of 900°C for three hours (180 minutes) to obtain a disk-shaped molybdenum material (hereinafter, also referred to as a "target") having a diameter of 330 mm and a thickness of 15 mm. This was used as a target of this example.

(Example 2)

In a 350 mm × 350 mm × 350 mm soft iron can, 210 kg of a molybdenum powder (purity, 5N; oxygen content, 15 ppm by mass) was enclosed and subjected to HIP treatment under the following conditions.

HIP treatment atmosphere: argon gas atmosphere
HIP treatment temperature: 1,250°C
HIP treatment pressure: 150 MPa
HIP treatment time: 5 hours

The resulting HIP-treated product was taken out from the can, and ground and cut to adjust the shape thereof to obtain a disk-shaped ingot having a diameter of 180 mm and a thickness of 50 mm.
The resulting ingot was heated to 1,200°C, and the heated ingot was then subjected to plastic working such that the compression rate (pressurizing rate) in the thickness direction of the ingot did not exceed 10 mm/s (i.e., such that the maximum pressurizing rate was 10 mm/s). When the material temperature decreased to 900°C or lower during working, the ingot was reheated in a furnace at 1,200°C for 10 minutes, and the plastic working was repeated until the dimensions were 330 mm in diameter and 15 mm in thickness (that is, until the total rolling reduction ratio reached 70%) to obtain a plastically worked product.
The resulting plastically worked product (worked ingot) was heat-treated in a hydrogen atmosphere at a heat treatment temperature of 1,100°C for three hours (180 minutes) to obtain a disk-shaped target having a diameter of 330 mm and a thickness of 15 mm. This was used as a target of this example.

(Comparative Example 1)

In a 350 mm × 350 mm × 350 mm soft iron can, 210 kg of a molybdenum powder (purity, 4N8; oxygen content, 10 ppm by mass) was enclosed and subjected to HIP treatment under the following conditions.

HIP treatment atmosphere: argon gas atmosphere
HIP treatment temperature: 1,250°C
HIP treatment pressure: 150 MPa
HIP treatment time: 5 hours

The resulting HIP-treated product was taken out from the can, and ground and cut to adjust the shape thereof to obtain a disk-shaped ingot having a diameter of 180 mm and a thickness of 50 mm.
The resulting ingot was heated to 1,350°C, and the heated ingot was then subjected to plastic working such that the compression rate in the thickness direction of the ingot did not exceed 25 mm/s. When the material temperature decreased to 1,100°C or lower during working, the ingot was reheated in a furnace at 1,350°C for 10 minutes, and the plastic working was repeated until the dimensions were 330 mm in diameter and 15 mm in thickness (that is, until the total rolling reduction ratio reached 70%) to obtain a plastically worked product.

The resulting plastically worked product (worked ingot) was heat-treated in a hydrogen atmosphere at a heat treatment temperature of 1,400°C for one hour (60 minutes) to obtain a disk-shaped target having a diameter of 330 mm and a thickness of 15 mm. This was used as a target of this example.

(Comparative Example 2)

In a 350 mm × 350 mm × 350 mm soft iron can, 210 kg of a molybdenum powder (purity, 4N8; oxygen content, 10 ppm by mass) was enclosed and subjected to HIP treatment under the following conditions.

HIP treatment atmosphere: argon gas atmosphere
HIP treatment temperature: 1,250°C
HIP treatment pressure: 150 MPa
HIP treatment time: 5 hours

The resulting HIP-treated product was taken out from the can, and ground and cut to adjust the shape thereof to obtain a disk-shaped ingot having a diameter of 180 mm and a thickness of 50 mm.

The resulting ingot was heated to 1,350°C, and the heated ingot was then subjected to plastic working such that the compression rate in the thickness direction of the ingot did not exceed 25 mm/s. When the material temperature decreased to 1,100°C or lower during working, the ingot was reheated in a furnace at 1,350°C for 10 minutes, and the plastic working was repeated until the dimensions were 330 mm in diameter and 15 mm in thickness (that is, until the total rolling reduction ratio reached 70%) to obtain a plastically worked product.

The resulting plastically worked product (worked ingot) was heat-treated in a hydrogen atmosphere at a heat treatment temperature of 1,500°C for one hour (60 minutes) to obtain a disk-shaped target having a diameter of 330 mm and a thickness of 15 mm. This was used as a target of this example.

<Evaluation of target>

(Scanning electron microscope-electron backscatter diffraction)

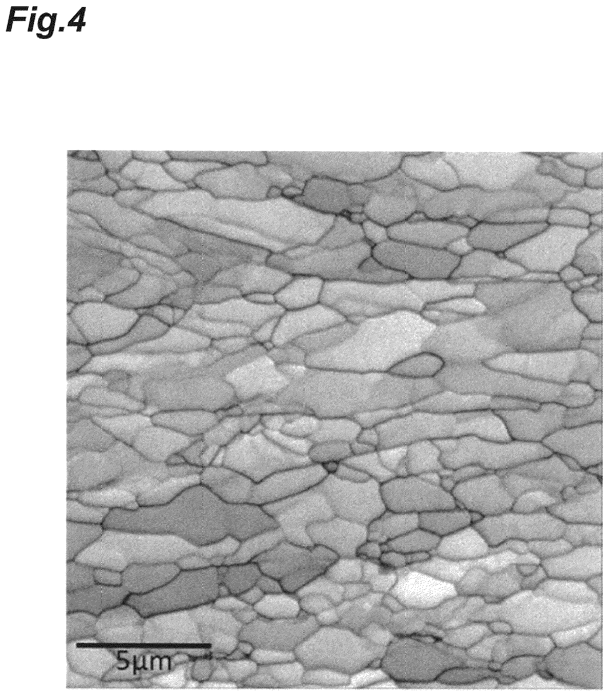

A scanning electron microscope-electron backscatter diffraction (SEM-EBSD) measurement was conducted by sampling and observing the following portion (sampling portion): a width of 5 mm radially inward from a position at a distance of 0.7R from the center of a circle with respect to a radius R of a circular sputtering surface of a disk-shaped target × t (mm) in overall thickness of the target. The measurement pretreatment, measurement conditions, and programs used for SEM-EBSD are described below. Figs. 4 and 5 show SEM observation images of sampling portions B in cross sections of the targets of Example 1 and Comparative Example 1, respectively.

·Measurement pretreatment

A pretreatment was performed by mirror-polishing with SiC abrasive paper and buffing, followed by electrolytic etching with a 5 vol% aqueous solution of sulfuric acid.

·Measurement conditions and programs used

(Measurement conditions)

Measurement conditions and programs used for SEM-EBSD are described below.

Apparatus name: JSM-IT800 (manufactured by JEOL Ltd.)
Beam conditions: Accelerating voltage 20 kV, Illumination current 100 μA
Work distance: 10 mm
Step width: 20 nm (Example 1), 200 nm (Example 2), 6 μm (Comparative Example 1),
12 μm (Comparative Example 2)

(Programs used)

Measurement program: AZtec
Analysis program: AZtec Crystal

(Purity)

The purity of the target was measured by glow discharge mass spectrometry (GDMS). Specifically, a specimen with a size of 10 mm × 10 mm × 5 mm was cut out from the target to prepare a measurement sample. The measurement sample was pretreated by being subjected to polishing with SiC abrasive paper (#800), followed by ultrasonic cleaning in pure water for 10 minutes, dehydration with an alcohol, hot-air drying, and subsequent vacuum packing. For the measurement sample after the pretreatment, the content (% by mass) of impurities (impurity metal elements) was measured by a method according to ASTM F 1593. The purity was calculated on the basis of the following formula. The results are shown in Table 2.

$$\text{Purity } (\%) = 100 - \text{content of impurities}$$

(Oxygen content)

The oxygen content of the target was measured with an oxygen/nitrogen analyzer (apparatus name: ON736, manufactured by LECO Corporation). In this measurement, a prism-shaped sample with a size of 4 mm × 4 mm × 5 mm cut out from the target by cutting was used as a measuring object. The results are shown in Table 2.

(Average crystal grain size)

The measurement of the average crystal grain size was performed using SEM-EBSD (SEM: manufactured by JEOL Ltd., EBSD: manufactured by Oxford Instruments). The microstructure of the target was observed under the following measurement conditions and using the following programs, and the measurement was performed for all the observed crystal grains using the analysis program (Aztec Crystal). Specifically, a rotation angle between adjacent measurement points, that is, the orientation difference (°) between measurement points was measured by EBSD in a SEM image, and a closed loop with continuous and uninterrupted pixel boundaries whose rotation angle exceeded 10° was regarded as a crystal grain boundary, and the region in the loop was defined as one crystal grain. The diameter of a circle having an area equivalent to the area of the region constituting a crystal grain was regarded as a grain size of the crystal grain, and the arithmetic mean of the grain sizes of all crystal grains measured was calculated as the average crystal grain size. The results are shown in Table 2.

(Measurement conditions)

Beam conditions: Accelerating voltage 20 kV, Illumination current 100 μA
Work distance: 10 mm

(Programs used)

Measurement program: AZtec
Analysis program: AZtec Crystal
(Maximum deviation of average crystal grain size)

The target was cut using a fine cutter in a direction parallel to the sputtering surface at positions at which the target was divided into three equal segments in the depth direction to obtain three divided segments. For each of the three divided segments, after surface polishing, the average crystal grain size on a surface on the sputtering surface side of the sampling portion B' was calculated, and the difference between the maximum value and the minimum value of these average crystal grain sizes was determined as the maximum deviation (μm). The results are shown in Table 2.

(Measurement of relative density)

The density of the target was measured in accordance with JIS R 1634 (Test methods of test methods for density and apparent porosity of fine ceramics), and the relative density (%) was calculated on the assumption that the true density of molybdenum is 10.22 g/cm$^3$. The results are shown in Table 2.

(Average KAM value)

The KAM (Kernel Average Misorientation) values were measured at all measurement points in the above sampling portion B, and the arithmetic mean value of the KAM values at all the measurement points was calculated. This arithmetic mean value was defined as an average KAM value of the target of each Example or each Comparative Example. The results are shown in Table 2.

[Table 1]

| | Raw material | Production process (Refining step) | | | | |
| --- | --- | --- | --- | --- | --- | --- |
| | | Plastic working step | | | Heat treatment step | |
| | Oxygen content (ppm) | Heating temperature of ingot (°C) | Maximum pressurizing rate (mm/sec) | Total rolling reduction ratio (%) | Heat treatment temperature (°C) | Time (min) |
| Example 1 | 15 | 800 | 10 | 70 | 900 | 180 |
| Example 2 | 15 | 1200 | 10 | 70 | 1100 | 180 |
| Comparative Example 1 | 10 | 1350 | 25 | 70 | 1400 | 60 |
| Comparative Example 2 | 10 | 1350 | 25 | 70 | 1500 | 60 |

[Table 2]

| | Target physical properties | | | | | |
| --- | --- | --- | --- | --- | --- | --- |
| | Relative density (%) | Purity (%) | Oxygen content (ppm by mass) | Average crystal grain size (μm) | Average crystal grain size maximum deviation (μm) | Average KAM value (°) |
| Example 1 | 100 | 99.999 | 15 | 1.36 | 0.07 | 0.25 |
| Example 2 | 100 | 99.999 | 15 | 3.93 | 1.24 | 0.34 |
| Comparative Example 1 | 100 | 99.998 | 10 | 110 | 67.0 | 0.24 |
| Comparative Example 2 | 100 | 99.998 | 10 | 700 | 393 | 0.20 |

In Table 1, the targets of Examples subjected to the refining step of the ingot under the production conditions shown in Table 1 were each confirmed to satisfy a relative density of 99.6% or more, an average crystal grain size of less than 10 μm, and an oxygen content of 100 ppm by mass or less, as shown in Table 2. On the other hand, the targets of Comparative Examples each had a high relative density but had an average crystal grain size of more than 100 μm, as shown in Table 2. Thus, the targets of Examples each have crystal grains finer than the targets of Comparative Examples, while having a high density and a low oxygen content; therefore, the generation of particles during deposition is considered to be more likely to be reduced.

Reference Signs List

1       sputtering target

10      substrate

11      sputtering surface

12      bonding surface

13      cross section

20      sputtering film

100     substrate with sputtering film

A       observation region

B       sampling portion

The present application is based on Japanese Patent Application (No. 2022-140343) filed on September 2, 2022, the entire contents of which are incorporated herein by reference. Furthermore, all the references cited herein are incorporated as a whole.

**Claims**

1.  A molybdenum sputtering target comprising molybdenum, wherein the molybdenum sputtering target contains crystal grains having an average crystal grain size of less than 10 $\mu$m and has a relative density of 99.6% or more and an oxygen content of 100 ppm by mass or less.

2.  The molybdenum sputtering target according to claim 1, wherein a purity is 99.9% or more.

3.  The molybdenum sputtering target according to claim 1 or 2, wherein a maximum deviation of the average crystal grain size of the crystal grains in a depth direction is 3 $\mu$m or less.

4.  The molybdenum sputtering target according to claim 3, wherein the maximum deviation is less than 1 $\mu$m.

5.  The molybdenum sputtering target according to claim 4, wherein the maximum deviation is 0.2 $\mu$m or less.

6.  The molybdenum sputtering target according to any one of claims 1 to 5, wherein the average crystal grain size is 5 $\mu$m or less.

7.  The molybdenum sputtering target according to any one of claims 1 to 6, wherein an average KAM value is 0.5° or less.

8.  The molybdenum sputtering target according to any one of claims 1 to 7, wherein a sputtering surface has an area of 200 cm$^2$ or more.

9.  A method for producing a sputtering film, the method comprising performing sputtering using the molybdenum sputtering target according to any one of claims 1 to 8 to produce a sputtering film.

10. A method for producing the molybdenum sputtering target according to any one of claims 1 to 8, the method comprising:

    a refining step of refining crystal grains in a molybdenum ingot,
    wherein the refining step includes a plastic working step of subjecting the molybdenum ingot to plastic working to obtain a plastically worked product and a heat treatment step of subjecting the plastically worked product to heating treatment.

# *Fig.1*

# Fig.2

Fig.3

*Fig.4*

**Fig.5**

## INTERNATIONAL SEARCH REPORT

| International application No. |
| --- |
| **PCT/JP2023/031580** |

| A. | CLASSIFICATION OF SUBJECT MATTER |
| --- | --- |

*C23C 14/34*(2006.01)i
FI:   C23C14/34 A

According to International Patent Classification (IPC) or to both national classification and IPC

| B. | FIELDS SEARCHED |
| --- | --- |

Minimum documentation searched (classification system followed by classification symbols)

C23C14/34

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | JP 2011-132563 A (TOSHIBA CORP) 07 July 2011 (2011-07-07)<br>        paragraphs [0004], [0009], [0024], [0026] | 1-2, 7-10 |
| A | | 3-6 |
| A | WO 2009/107763 A1 (NIPPON STEEL MATERIALS CO., LTD.) 03 September 2009 (2009-09-03)<br>        entire text, all drawings | 1-10 |
| A | WO 2020/054104 A1 (JX NIPPON MINING & METALS CORP) 19 March 2020 (2020-03-19)<br>        entire text, all drawings | 1-10 |
| A | WO 2017/033694 A1 (MITSUBISHI MATERIALS CORP) 02 March 2017 (2017-03-02)<br>        entire text, all drawings | 1-10 |
| A | JP 10-183341 A (HITACHI METALS LTD) 14 July 1998 (1998-07-14)<br>        entire text, all drawings | 1-10 |

☐ Further documents are listed in the continuation of Box C.      ☑ See patent family annex.

| * Special categories of cited documents: | |
| --- | --- |
| "A" document defining the general state of the art which is not considered to be of particular relevance | "T" later document published after the international filing date or priority date and not in conflict with the application but cited to understand the principle or theory underlying the invention |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **10 November 2023** | **21 November 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/031580**

| Patent document cited in search report | | | Publication date (day/month/year) | Patent family member(s) | | | Publication date (day/month/year) |
|---|---|---|---|---|---|---|---|
| JP | 2011-132563 | A | 07 July 2011 | (Family: none) | | | |
| WO | 2009/107763 | A1 | 03 September 2009 | CN | 101960042 | A | |
| | | | | KR | 10-2010-0116213 | A | |
| | | | | TW | 201002842 | A | |
| WO | 2020/054104 | A1 | 19 March 2020 | US | 2020/0263291 | A1 | |
| | | | | EP | 3643807 | A1 | |
| | | | | KR | 0-2020-0032097 | A | |
| | | | | CN | 111465712 | A | |
| | | | | TW | 202010856 | A | |
| WO | 2017/033694 | A1 | 02 March 2017 | US | 2018/0237901 | A1 | |
| | | | | EP | 3342898 | A1 | |
| | | | | CN | 107923034 | A | |
| | | | | KR | 10-2018-0043245 | A | |
| | | | | TW | 201726930 | A | |
| JP | 10-183341 | A | 14 July 1998 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005154814 A
- JP 2012043227 A
- JP 2000045066 A
- JP 2022140343 A